(19) Europäisches Patentamt
European Patent Office
Office européen des brevets

(11) Publication number: **0 430 166 A2**

# (12) EUROPEAN PATENT APPLICATION

(21) Application number: **90122647.2**

(22) Date of filing: **27.11.90**

(51) Int. Cl.5: **H01L 21/3215**, H01L 21/3205

(30) Priority: **01.12.89 JP 313721/89**
**01.12.89 JP 313723/89**

(43) Date of publication of application:
**05.06.91 Bulletin 91/23**

(84) Designated Contracting States:
**DE FR GB Bulletin 00/1**

(71) Applicant: **SEIKO INSTRUMENTS INC.**
**31-1, Kameido 6-chome Koto-ku**
**Tokyo 136(JP)**

(72) Inventor: **Aoki, Kenji, c/o Seiko Instruments Inc.**
**31-1, Kameido 6-chome**
**Koto-ku, Tokyo(JP)**
Inventor: **Akamine, Tadao, c/o Seiko Instruments Inc.**
**31-1, Kameido 6-chome**
**Koto-ku, Tokyo(JP)**
Inventor: **Saito, Naoto, c/o Seiko Instruments Inc.**
**31-1, Kameido 6-chome**
**Koto-ku, Tokyo(JP)**

(74) Representative: **Fleuchaus, Leo, Dipl.-Ing. et al**
**Melchiorstrasse 42**
**W-8000 München 71(DE)**

## (54) Method of doping impurity into semiconductor films and patterned semiconductor strip.

(57) A patterned semiconductor strip is provided on a substrate. An inert coating is removed from a surface of the semiconductor strip to expose an active surface. A source gas containing an impurity component is applied to the exposed active surface to adsorb thereon an impurity film containing the impurity component. The substrate is heated to diffuse the impurity component from the impurity film into the semiconductor strip and to activate the diffused impurity component.

FIG. 1A

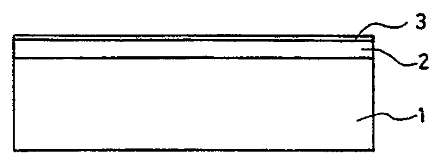


FIG. 1B

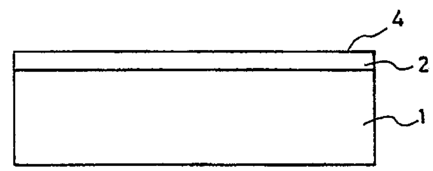


FIG. 1C

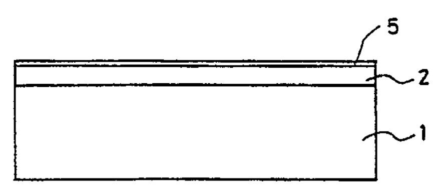


FIG. 1D

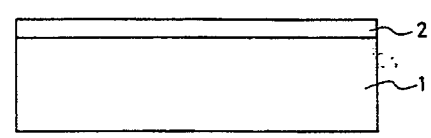


EP 0 430 166 A2

# METHOD OF DOPING IMPURITY INTO SEMICONDUCTOR FILMS AND PATTERNED SEMICONDUCTOR STRIP

## BACKGROUND OF THE INVENTION

The present invention relates to the method of doping impurity into semiconductor films and a patterned semiconductor strip which is a component of a semiconductor device.

Conventionally, an impurity is doped into a patterned semiconductor strip so as to impart thereto desired electric characteristics. The doping of impurity is effected conventionally by ion implantation or predeposition diffusion.

However, the conventional ion implantation has drawbacks that impurity atoms would pass through the objective patterned semiconductor strip to damage or contaminate another device element disposed under the simiconductor strip, since the implanted impurity atoms are doped in Gaussian distribution in the depth direction due to variation of accelerating energy of individual impurity ions. On the other hand, the conventional predeposition diffusion has drawbacks that the impurity concentration and diffusion depth could not be controlled since the impurity is introduced into a patterned semiconductor strip through an oxide film barrier, such as BSG or PSG, existing on the strip.

## SUMMARY OF THE INVENTION

In view of the above noted drawbacks of the prior art, an object of the present invention is to provide a new method of doping impurity selectively and limitatively into a semiconductor strip while controlling impurity density distribution.

## BRIEF DESCRIPTION OF THE DRAWINGS

Figs. 1A-1D are a basic process step diagram of the inventive impurity doping method;

Fig. 2 is a block diagram of an apparatus for carrying out the impurity doping;

Fig. 3 is a graph showing the relation between a sheet resistance of a semiconductor strip doped by impurity and a charging amount of impurity source gas;

Figs. 4A-4D are a doping step diagram of a lead pattern layer;

Figs. 5A-5D are a process step diagram of a patterned resistive film;

Figs. 6A-6D are another process step diagram of a patterned resistive film;

Figs. 7A-7D are a process step diagram of a patterned gate electrode;

Figs. 8A-8E are another process step diagram of a patterned gate electrode;

Figs. 9A-9E are a process step diagram of a diffusion resistive element;

Fig. 10 is an impurity concentration profile of a diffusion resistive layer in the depth direction;

Figs. 11A-11C are another process step diagram of a diffusion resistive element;

Fig. 12 is a process sequence chart of the method shown in Figs. 11A-11C;

Fig. 13 is a graph showing the relation between a sheet resistance of the diffusion resistive layer and annealing time period; and

Figs. 14A and 14B are a further process step diagram of a diffusion resistive element.

## DETAILED DESCRIPTION OF THE INVENTION

Figs. 1A-1D show a basic processing step diagram of the inventive method of doping an impurity into a patterned semiconductor strip. In the Fig. 1A step, a patterned semiconductor strip is deposited on a substrate 1 in the form of a semiconductor film 2 which may be composed of silicon single crystal, polysilicon or amorphous silicon. As shown in the figure, a surface of the semiconductor film 2 is generaly coated by an inert film 3, such as natural oxide.

Subsequently in the Fig. 1B step, the inert film 3 is removed from the surface of semiconductor film 2 in a vacuum chamber to expose an active surface of the semiconductor film 2. This treatment is carried out such that the substrate 1 is placed in the vacuum chamber while heating the substrate 1. Preferably, a reductive gas such as hydrogen is introduced concurrently.

Next in the Fig. 1C step, an impurity film 5 is adsorbed on the active surface 4 of the semiconductor film 2 in the same vacuum chamber. This adsorption treatment is carried out such that a diborane gas containing an impurity component of boron is applied to the active surface 4 to adsorb the impurity component on the active surface 4 while heating the substrate 1. This impurity film 5 is composed substantially of boron element or boron compound.

Lastly in the Fig. 1D step, the substrate 1 is heated so that the impurity boron contained in the impurity film 5 is uniformly diffused into the semiconductor film 2. Namely, solid-phase diffusion is carried out from an impurity diffusion source in the form of the impurity adsorption film 5 formed in the Fig. 1C step. The diffused impurity is activated concurrently.

Fig. 2 shows an apparatus for use in practicing the above described method of doping impurity. As shown in the figure, the apparatus is comprised of a vacuum chamber 12 made of quartz, in which is placed centrally a substrate 1 formed with a patterned semiconductor film. A heating system 13 is disposed around the chamber 12 to control a temperature of the substrate 1 by means of an infrared lamp heater or resistance heater. A high vacuum evacuation system 14 is comprised of plural pumps including a main pump in the form of a turbo molecular pump, and is connected to evacuate the chamber 12 in high vacuum state. A pressure gage 15 is connected to continuously monitor vacuum degree of the chamber 12. A transportation mechanism 18 is provided to transport the substrate 1 to the main chamber 12 from a loading chamber 17 through an opened gate valve 16a disposed therebetween. An evacuation system 19 is provided to normally vacuum the loading chamber 17 while opening another gate valve 16b except other than during loading and unloading of substrate to and from the loading chamber 17 and transportation of the substrate between the main chamber 12 and the loading chamber 17. A gas supply source 21 is connected to the chamber 12 through a gas flow control system 20. The gas supply source 21 has a plurality of bottles storing various gas species needed for processing. The gas flow control system 20 is operated to control gas species, pressure and charging time of source gas introduced into the chamber 12 from the gas supply source 21.

Next, the description is given for the method of doping a P type impurity of boron into a patterned semiconductor film formed on the substrate 1. Firstly, cleaning treatment of the semiconductor film surface is carried out to expose an active surface. Namely, the substrate 1 is placed in a center of the vacuum chamber 12 which is held at less than 1 x $10^{-4}$ Pa of background pressure, and the substrate temperature is held at, for example, 850 °C. In this condition, hydrogen gas is charged from the gas supply source 21 to the chamber 12 for a predetermined time interval so as to raise the chamber pressure to, for example, 1.3 x $10^{-2}$ Pa. By this operation, an inert film i.e., natural oxide film is removed to expose a chemically active silicon surface. This cleaning treatment could be also carried out by simply placing the substrate 1 in high vacuum and heating the same without using a reductive gas. After completion of the semiconductor film surface cleaning, the hydrogen gas is stopped and the substrate temperature is lowered to, for example, 800 °C. After reaching this set temperature stably, the chamber 12 is supplied with a compound gas of diborane( $B_2H_6$) diluted to 5% by nitrogen gas for a predetermined time interval so as to set 1.3 x $10^{-2}$

Pa of the chamber pressure. Consequently, the semiconductor film is covered on its active surface by an adsorption film containing boron element or boron compound. Since the substrate 1 is heated in this treatment, a part of boron may be diffused into the semiconductor film from the adsorption film. Lastly, the substrate 1 is annealed to facilitate the diffusion of boron into the semiconductor film. Namely, after forming the adsorption film, the diborane gas is stopped and the substrate 1 is heated in vacuum to effect diffusion of the impurity from a diffusion source composed of the adsorption film 5 to the semiconductor film 2 as shown in Fig. 1D. Concurrently, the diffused impurity of boron atoms are activated. According to the invention, amount of adsorbed boron and annealing condition, i.e., heating temperature and time are controlled so as to obtain a doped semiconductor film having desired impurity concentration and diffusion depth.

Fig. 3 is a graph showing the relation between sheet resistance of the thus obtained doped semiconductor film and charging amount of diborane gas. In this case, annealing conditions are all same. As understood from the Fig. 3 graph, the sheet resistance of the doped semiconductor film is controlled by suitably setting the charging amount of the diborane gas.

As apparent from the above description, the inventive method features basically that an adsorption film containing at least impurity element is formed on the active surface of the semiconductor film as a diffusion source, and the impurity element is doped into the semiconductor film from the impurity diffusion source composed of the adsorption film. According to the detailed study by the inventors, it is found that an impurity adsorption film is substantially not formed on the inert film such as natural oxide film in a predetermined substrate temperature range in contrast to the active surface of the semiconductor film. Otherwise, the adsorbed impurity remains on the inert film only one-tenth or less than the active surface. Particularly, when boron adsorbs on a surface of the silicon semiconductor film, the amount of adsorbed boron is not only smaller on the inert coating layer than on the active surface, but also the boron adsorption film is unstable on the inert coating layer during the course of annealing step after the formation of adsorption film as compared to the boron adsorption film on the active surface.

This invention is not limited to the use of diborane gas for doping boron into a semiconductor film. Besides diborane, the doping of P type impurity can be carried out by using various compound gases of the III-group elements, such as trimethyl gallium (TMG) and boron trichloride ( $BCl_3$). On the other hand, an N type impurity can be doped into the silicon semiconductor film by using various source gases such as arsine ( $AsH_3$), phosphorus trichloride ( $PCl_3$), antimony pentach-

loride ( $SbCl_5$) and phosphine ($PH_3$).

According to the inventors' study, the substrate temperature should be preferably set in the range from 800 °C to 1200 °C in conjunction with the background pressure and ambient gas species for the surface cleaning treatment of the semiconductor film. The substrate temperature should be preferably set in the range from 400 °C to 950 °C for the adsorption treatment, and in the moderately higher range for the annealing treatment.

The adsorption film is not only directly formed on the active surface of the semiconductor film, but also an under-layer composed of silicon single crystal may be interposed by epitaxial growth. Otherwise, a silicon single crystal film may be added over the adsorption film by means of epitaxial growth. Further, an adsorption layer and an epitaxial layer are superposed to each other in multilayer structure. Still further, adsorption treatment and annealing treatment may be repeatedly and alternatively carried out to obtain a desired impurity doping density.

EXAMPLE 1

Hereinafter, various examples of the inventive impurity doping method will be described in conjunction with the drawings. Figs. 4A-4D show a first example of doping an impurity of boron into a patterned polysilicon film used as a lead pattern in a semiconductor device. In the Fig. 4A step, there is provided a substrate 41 formed thereon with an insulating gate field effect transistor. Each transistor device is comprised of a source region 42, a drain region 43, a gate insulating film 44 disposed to cover a channel region formed between the source and drain regions, and a gate electrode 45 formed on the gate insulating film 44. Further, the transistor device is covered by an inter-layer insulating film 46, which is formed with contact holes for electrical connections to the source region 42, drain region 43 and gate electrode 45.

In the Fig. 4B step, a polysilicon film 47 is formed over the substrate surface. This polysilicon film 47 will be patterned in a later step to form a transistor lead pattern. The polysilicon film 47 is deposited by chemical vapor deposition while maintaining a temperature of the substrate 41 in the range from 600 °C to 700 °C. This deposited layer is utilized as a lead pattern, hence an impurity should be doped thereinto so as to increase electroconductivity thereof.

In the Fig. 4C step, a natural oxide film is removed from a surface of the polysilicon film 47 to expose an active surface. Then, diborane gas is applied to the exposed active surface to adsorb an impurity layer 48 containing boron element or boron compound. The adsorption amount can be adjusted by suitably setting pressure and charging time interval of the introduced diborane gas.

Lastly in the Fig. 4D step, the substrate 41 is thermally treated to quickly diffuse boron atoms contained in the impurity adsorption layer 48 into the polysilicon film 47 uniformly. Consequently, the polysilicon film 47 has a desired conductivity to function as a lead pattern.

EXAMPLE 2

Figs. 5A-5D show application of the inventive doping method to a film resistive element. In the Fig. 5A step, there is provided a substrate 51 formed thereon with a pair of electrode regions 52 and 53. An insulating film 54 is also formed between the pair of electrode regions 52 and 53. The substrate 51 is composed of silicon, the electrode regions 52 and 53 are of a $P^+$ type impurity region, and the insulating film 54 is composed of silicon oxide.

In the Fig. 5B step, a silicon semiconductor film 55 is deposited over the surface of substrate 51, and is then etched in a desired pattern. The silicon semiconductor film 55 is composed of polysilicon or amorphous silicon.

In the Fig. 5C step, the surface of the silicon semiconductor film 55 is cleaned, and subsequently diborane gas is applied so as to adsorb an impurity layer 56. In the last step of Fig. 5D, the substrate 51 is annealed so that the impurity boron contained in the impurity adsorption layer 56 is uniformly diffused into the semiconductor film 55. Consequently, the patterened semiconductor film 55 is imparted with a desired resistivity to produce a film resistor.

EXAMPLE 3

Figs. 6A-6D show a third example of application of the inventive impurity doping method to the production of another type of film resistor. Firstly as shown in Fig. 6A, there is provided a substrate 61, which is composed of insulating material and is deposited thereon with a polysilicon film 62 patterned in a desired shape.

Subsequently in the Fig. 6B step, a surface of the polysilicon film 62 is cleaned to expose an active surface. Diborane gas is applied to the active surface to adsorb an impurity layer 63.

In the Fig. 6C step, annealing treatment is carried out so that the impurity boron contained in the adsorption layer 63 is uniformly diffused into the polysilicon film 62.

Lastly in the Fig. 6D step, the semiconductor film 62 is coated by an insulating film 64 and a pair of contact holes are formed through the insulating film 64. A metal layer 65 is deposited on the insulating film 64 by evaporation, and is then patterned in a desired shape to produce a film resistor device.

As described in conjunction with Figs. 5A-5D and Figs. 6A-6D, according to the inventive method, impurity can be effectively doped into a significantly thin semiconductor film having the thickness of less than 0.1 $\mu$ m without contaminating other part of the device. The doped impurity density and the diffusion depth can be controlled efficiently.

EXAMPLE 4

Figs. 7A-7D show a fourth example of the application of the inventive impurity doping method to processing of a gate electrode of Metal Insulator Semiconductor Field Effect Transistor(MISFET). In the Fig. 7A step, there is provided a substrate 71 which is composed of silicon single crystal and is formed sequentially thereon with a gate insulating film 72 and a polysilicon film 73.

In the Fig. 78 step, a natural oxide film is removed from a surface of the polysilicon film 73, and thereafter diborane gas is used to adsorb an impurity layer 74.

In the Fig. 7C step, the silicon substrate 71 is annealed to diffuse uniformly the impurity boron contained in the impurity layer 74 into the polysilicon film 73. Consequently, a desired low resistivity is established in the polysilicon film 73 according to the amount of doped boron.

Lastly in the Fig. 7D step, the polysilicon film 73 doped with the impurity boron is patterned to obtain a gate electrode. According to the inventive doping method, adsorption and diffusion of boron can be carried out in relatively low processing temperature of more or less 800°C which is advantageous in the transistor device fabrication.

EXAMPLE 5

Figs. 8A-8E show a fifth example of the application of the inventive impurity doping method to the processing of a gate electrode. The fifth example relates to the processing of an N type gate electrode in contrast to the previous fourth example which relates to the processing of a P type gate electrode. In the Fig. 8A step, there is prepared a silicon substrate 81 on which a gate insulating film 82 and a polysilicon film 83 are formed sequentially.

In the Fig. 8B step, an N type impurity is doped into the polysilicon film 83 by means of the ion implantation, the conventional predeposition diffusion or the inventive doping method. By doping high density of the N type impurity, the polysilicon film 83 is turned to an $N^+$ type semiconductor film.

In the Fig. 8C step, a surface of the $N^+$ type semiconductor film 83 is cleaned, and thereafter an impurity layer 84 is adsorbed by using, for example, diborane gas. This adsorption amount is quite accurately controlled by regulating charging pressure and charging duration of the diborane gas.

In the Fig. 8D step, the substrate 81 is heated so that the impurity boron is diffused from the very thin impurity layer 84 into the $N^+$ type semiconductor film 83 disposed under the impurity layer 84, limitatively within a very shallow depth. Consequently, the $N^+$ type semiconductor film 83 is covered by $N^-$ type polysilicon layer 85. Namely, the precedingly doped N type impurity of the $N^+$ type semiconductor film 83 is canceled by the succeedingly doped P type impurity on the surface portion of the semiconductor film 83 so that the density of N type impurity is effectively lowered.

Lastly in the Fig. 8E step, the semiconductor film 83 is patterned in a desired shape to form an N type gate electrode. In this example, the $N^-$ type polysilicon layer is formed on the $N^+$ type semiconductor film 83, hence formation of natural oxide on the gate electrode will be suppressed effectively, and generation of water mark may be prevented.

As described above, according to the invention, an impurity is efficiently doped into a semiconductor film by sequencial steps of cleaning a semiconductor film, adsorbing an impurity, and annealing the substrate. Diffusion density and depth of the impurity can be quite accurately controlled by regulating gas pressure and gas charging time of the impurity source material. Further, the inventive impurity doping method is advantageous in that a semiconductor device is not contaminated by the impurity other than the objective semiconductor film as opposed to the conventional ion implantation.

EXAMPLE 6

Figs. 9A-9E show a sixth example of the application of the inventive method to fabrication of a diffusion resistive element, in which an impurity is doped into a patterned strip in the form of a surface layer of a semiconductor substrate. Firstly as shown in the Fig. 9A step, an insulating film 92 is formed on a semiconductor substrate 91 composed of silicon. This insulating film 92 is provided by chemical vapor deposition of silicon dioxide or silicon nitride. Thereafter, the insulating film 92 is partly removed to form a patterned device region 93 which is a part of a surface layer of the semiconductor substrate 91. The device region 93 is generally covered by an inert coating such as a natural oxide film 94.

In the Fig. 9B step, the surface of device region 93 is cleand to expose an active surface of the semiconductor surface layer. In this cleaning treatment, the silicon semiconductor substrate 91 is placed in a vacuum chamber held at less than 1 x $10^{-4}$ Pa of background pressure. Then, the substrate temperature is set to 850°C and hydrogen gas is introduced into the chamber for a predetermined period so as to set 1.3 x $10^{-2}$ Pa of the chamber inner pressure. By this treatment, the natural oxide film 94 is removed from the surface layer of the silicon semiconductor substrate 91 to expose a chemically active silicon surface.

In the Fig. 9C step, diborane gas having an impurity component of boron is applied to the silicon semiconductor substrate 91 to thereby form an impurity adsorption film 95 containing boron, selectively, on the device region 93. This adsorption treatment is carried out after stopping the hydrogen gas used to clean the silicon surface. The substrate temperature is set to 825°C. After reaching that set temperature stably, the surface of the silicon semiconductor substrate 91 is applied with a source gas containing diborane ( $B_2H_6$) dilluted to 5% by nitrogen gas for a predetermined time so as to set the vacuum chamber pressure to 1.3 x $10^{-2}$ Pa. By this operation, there is formed an adsorption film 95 composed of boron element or boron compound. The pressure and charging time of the diborane gas is suitably set to regulate an adsorption rate of boron.

In the Fig. 9D step, solid-phase diffusion and activation of the impurity boron is carried out from a diffusion source comprised of the impurity adsorption film 95 to form a diffusion resistive layer 96 within the device region 93 in the form of a patterned strip. This diffusion processing is carried out by annealing the substrate 91 in vacuum after stopping the diborane gas. Annealing temperature is set to, for example, 825°C. The diffusion resistive layer 96 is imparted with a desired impurity density and junction depth by controlling amount of adsorbed boron and annealing condition, i.e., temperature and time.

Lastly in the Fig. 9E step, a pair of electrodes 97 are connected to the diffusion resistive layer 96 to complete a diffusion resistor device. The electrodes 97 are formed such that metal is evaporated on the diffusion resistive layer 96 through a pair of contact holes, and then the metal film 97 is etched in a desired pattern.

Fig. 10 shows a boron density profile in the depth direction of a diffusion resistive layer formed by the sequential steps of Figs. 9A - 9E. This density profile is obtained by using a secondary ion mass-spectrometer. A sample substrate surface is covered by about 450Å of amorphous silicon coating in order to increase analysis sensitivity. Therefore, the original substrate surface level is indicated at about 45 nm along the horizontal axis in the Fig. 10 graph. As seen from the graph, the diffusion resistive layer has about 700Å depth of significantly shallow, and its impurity density profile is significantly steep at a PN junction. In addition, sheet resistance of the thus obtained diffusion resistive layer can be desirably set by adjusting charging time and other parameters of diborane gas application.

According to the above described example, the impurity gas is applied directly to the semiconductor active surface exposed on the device region while heating the substrate so as to form the impurity adsorption film. This adsorption film is chemically bonded to the active surface in firm and stable state. The solid-phase diffusion and activation of the impurity is carried out from a diffusion source comprised of the impurity adsorption film to form the diffusion resistive layer in the device region. This diffusion resistive layer has significantly steep density profile in the depth direction of the substrate, hence a depletion layer has a small width at the junction between the diffusion resistive layer and the substrate semiconductor layer. Therefore, the resistivity in the vicinity of the depletion layer is not easily varied by applied voltage. Consequently, there can be obtained a semiconductor diffusion resistive pattern having good characteristics.

## EXAMPLE 7

Figs. 11A-11C show another process step diagram of the method of producing a diffusion resistive element. In the Fig. 11A step, an insulating film 112 is formed on a surface of a silicon substrate 111. The insulating film 112 is removed partly by etching to form a device region 113. Subsequently, a semiconductor film 114 is formed by under-layer treatment within the device region 113. This semiconductor film 114 is obtained, for example, by epitaxial growth of silicon. In this example, a molecular layer epitaxy is carried out with using a source gas comprised of dichlorosilane ( $SiH_2Cl_2$). By this treatment, there is provided the semiconductor film 114 composed of an epitaxial layer having less than 100Å of thickness at the substrate temperature of 825°C. The epitaxial layer can be formed by other methods such as molecular beam epitaxy and chemical vapor deposition than the above described method.

In the Fig. 11B step, a surface of the silicon semiconductor film 114 is cleand, and then diborane gas is introduced to form an impurity adsorption film 115. These sequential treatments can be carried out in manner similar to the sixth example.

Lastly in the Fig. 11C step, the substrate 111 is heated such that the impurity boron contained in the adsorption film 115 is diffused into the semiconductor film 114 of the under-layer to thereby form a diffusion resistive layer 116.

Fig. 12 is an actual process sequence chart corresponding to the sequential steps of Figs. 11A-11C. The horizontal axis indicates processing time and the vertical axis indicates substrate temperature in the process sequence chart. As shown in the chart, the substrate is placed in a vacuum chamber, and thereafter the substrate temperature is raised to 850°C and is stabilized at that set temperature. Then, hydrogen gas is introduced into the chamber to carry out cleaning of the substrate surface to expose an active surface. Next, the substrate temperature is lowered from 850°C to 825°C and epitaxial growth is carried out to form a silicon single crystal film. This treatment is effected by introducing dichlorosilane gas into the chamber for about 15 minutes. Consequently, a silicon epitaxial layer is formed at about 100Å of thickness. Then, diborane gas is charged into the chamber while maintaining the substrate temperature at 825°C to form an impurity adsorption film. Lastly, annealing is carried out at the substrate temperature of 825°C for about 5 minutes to thereby diffuse the impurity boron into the epitaxial growth layer to form a diffusion resistive layer. Thereafter, the substrate temperature is lowered to an ambient level and the substrate is taken from the chamber.

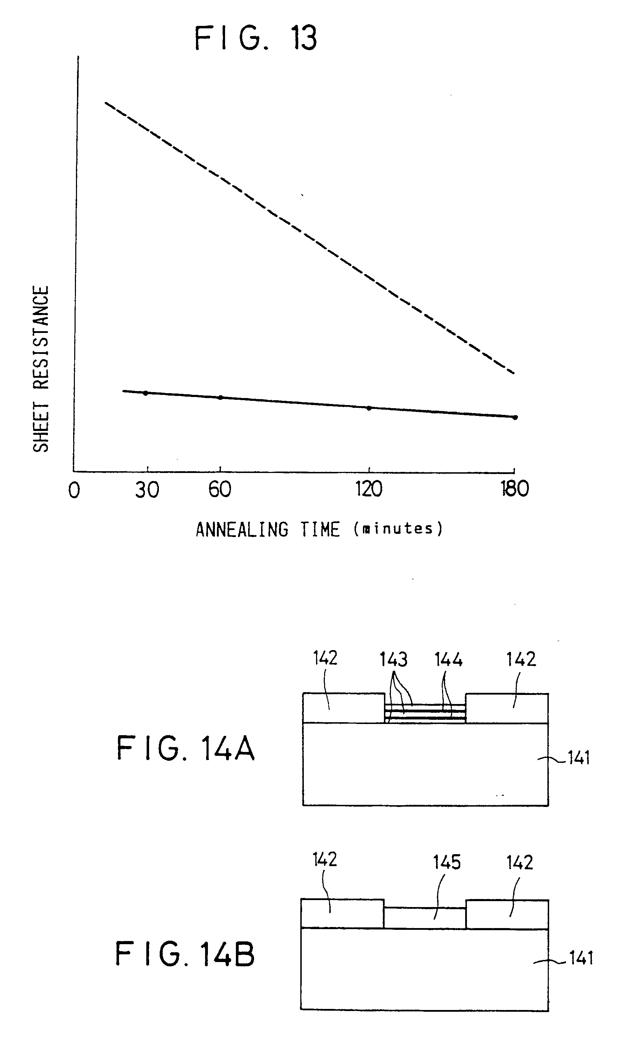

Fig. 13 shows the relation between the sheet resistance value of the diffusion resistive layer and the annealing time interval. In the Fig. 13 graph, the solid line relates to a oase where an additional silicon epitaxial growth layer is formed on the precedingly deposited impurity adsorption film, and the broken line relates to another case where such additional silicon epitaxial growth layer is not provided on the substrate. As understood from the graph, when the silicon epitaxial growth layer is added after the formation of the impurity adsorption film, the sheet resistance value of the diffusion resistive layer substantially does not depend on the annealing time and therefore is quite stable. On the other hand, when such silicon epitaxial growth layer is not coated over the impurity adsorption film deposited on the active surface of the silicon substrate, the obtained diffusion resistive layer has a sheet resistance value greatly depending on the annealing time interval. Accordingly, by forming an epitaxial growth layer over the impurity adsorption film, the sheet resistance value can be controlled stably in lower range in the diffusion resistive layer. Aside from above, the annealing may be carried out so as to activate the impurity after the formation of the impurity adsorption film by means of ramp anneal method or rapid thermal anneal method effective to reduce the depth or thickness of the diffusion resistive layer.

EXAMPLE 8

Figs. 14A and 14B show a further embodiment of producing a diffusion resistive layer. In the Fig. 14A step, an insulating film 142 is selectively formed on a silicon substrate 141 to provide a device region. A silicon epitaxial layer 143 and a boron adsorption film layer 144 are alternatively and successively deposited on the device region.

In the Fig. 14B step, the substrate 141 is annealed so that the impurity boron contained in the adsorption films 144 is diffused into adjacent silicon epitaxial layers 143. Consequently, a diffusion resistive layer 145 having a predetermined thickness is formed within the device region. The thickness of the diffusion resistive layer can be controlled in this manner by depositing alternatively the impurity adsorption film and the epitaxial growth film.

As described above, according to the invention, a desired diffusion resistive layer can be obtained by the sequential steps of cleaning a surface of a semiconductor layer to expose an active surface, forming an impurity adsorption film on the exposed active surface, and annealing the substrate to diffuse the impurity. Therefore, the diffused impurity has a quite steep or sharp density profile in the depth direction so as to efficiently avoid formation of depletion layer at the junction between the diffusion layer and the semiconductor layer, thereby effectively reducing dependency of the resistance of the diffusion resistive layer on the applied voltage. Further, by controlling pressure and charging time of the impurity source gas applied to an active surface of a semiconductor layer, an impurity adsorption film can be deposited at a desired amount, thereby achieving a suitable sheet resistance value in the diffusion resistive layer.

## Claims

**1.** A method of doping an impurity, comprising:

first step of forming a patterned semiconductor strip on a substrate;

second step of removing an inert coating from the semiconductor strip to expose an active surface;

third step of applying a gas containing an impurity component to the active surface to adsorb thereon the impurity component to thereby form an impurity film;

the fourth step of heating the substrate to diffuse the impurity component from the impurity film into the patterned semiconductor strip and activating the diffused impurity component.

2. A method according to claim 1; wherein the patterned semiconductor strip is provided in the form of a semiconductor film.

3. A method according to claim 2; wherein the third step comprises applying diborane gas containing an impurity component of boron to an active surface of a semiconductor film composed of silicon.

4. A method according to claim 1; wherein the first step comprises forming a polysilicon semiconductor film.

5. A method according to claim 4; wherein the fourth step comprises diffusing the boron uniformly into a lead pattern composed of the polysilicon semiconductor film patterned on the substrate.

6. A method according to claim 4; wherein the fourth step comprises diffusing boron into a strip of the polysilicon semiconductor film formed on an insulating film coated over the substrate so as to provide a strip of film resistor element.

7. A method according to claim 4; wherein the fourth step comprises diffusing uniformly boron into a gate electrode composed of the polysilicon semiconductor film formed on a gate insulating film coated over a semiconductor substrate.

8. A method according to claim 4; wherein the fourth step comprising diffusing lightly boron into a gate electrode composed of $N^+$ type polysilicon semiconductor film formed on a gate insulating film coated on a semiconductor substrate so as to form a coating of $N^-$ type polysilicon.

9. A method according to claim 1; wherein the first step comprises forming a silicon single crystal semiconductor film.

10. A method according to claim 9; wherein the fourth step comprises diffusing boron into a strip of the silicon single crystal semiconductor film to form a strip of a film resistor element.

11. A method according to claim 1; wherein the first step comprises forming an amorphous silicon semiconductor film.

12. A method according to claim 11; wherein the fourth step comprises diffusing boron into a strip of the amorphous silicon semiconductor film so as to form a strip of a film resistor element.

13. A method according to claim 1; wherein the first step comprises forming an insulating film over the substrate, and removing a part thereof so as to provide a device region having a patterned semiconductor strip, and the fourth step comprises diffusing the impurity component into the patterned semiconductor strip to form a diffusion resistive layer; and including the fifth step of connecting a pair of electrodes to the diffusion resistive layer to thereby produce a diffusion resistive element.

14. A method according to claim 13; wherein the third step comprises applying diborane gas containing an impurity component of boron to the patterned semiconductor strip in the form of a surface layer of the substrate composed of silicon so as to form an impurity film containing the boron within the device region.

15. A method according to claim 14; including the additional step of providing a silicon semiconductor film in contact with the impurity film.

16. A method according to claim 15; wherein the third step and the additional step are repeatedly carried out so as to form a multi-layer comprised of impurity films and silicon semiconductor films within the device region.

17. A method according to claim 15; wherein the additional step comprises epitaxially growing a silicon semiconductor film.

FIG.1A

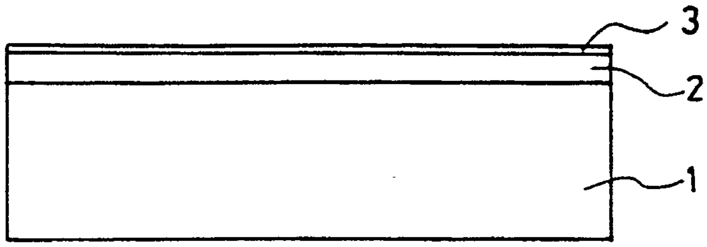


FIG.1B

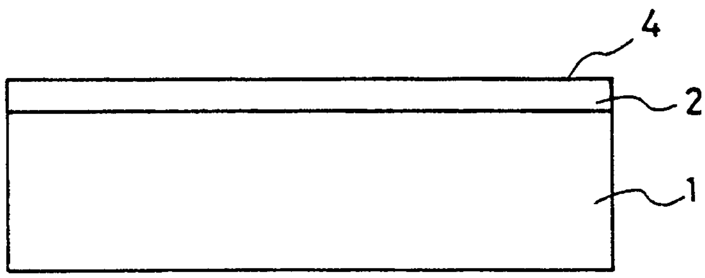


FIG.1C

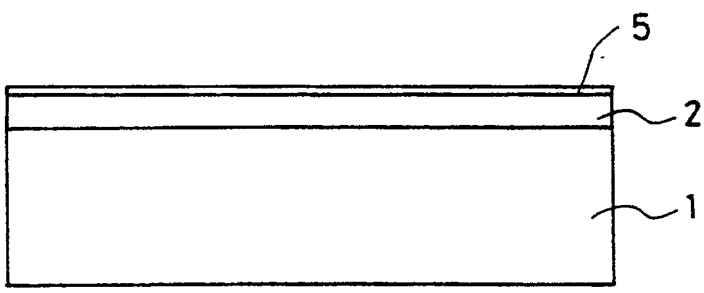


FIG.1D

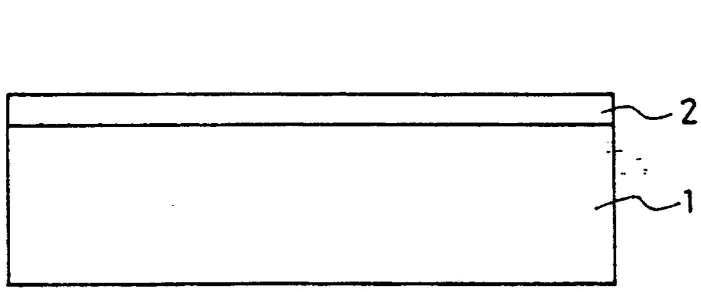

FIG. 2

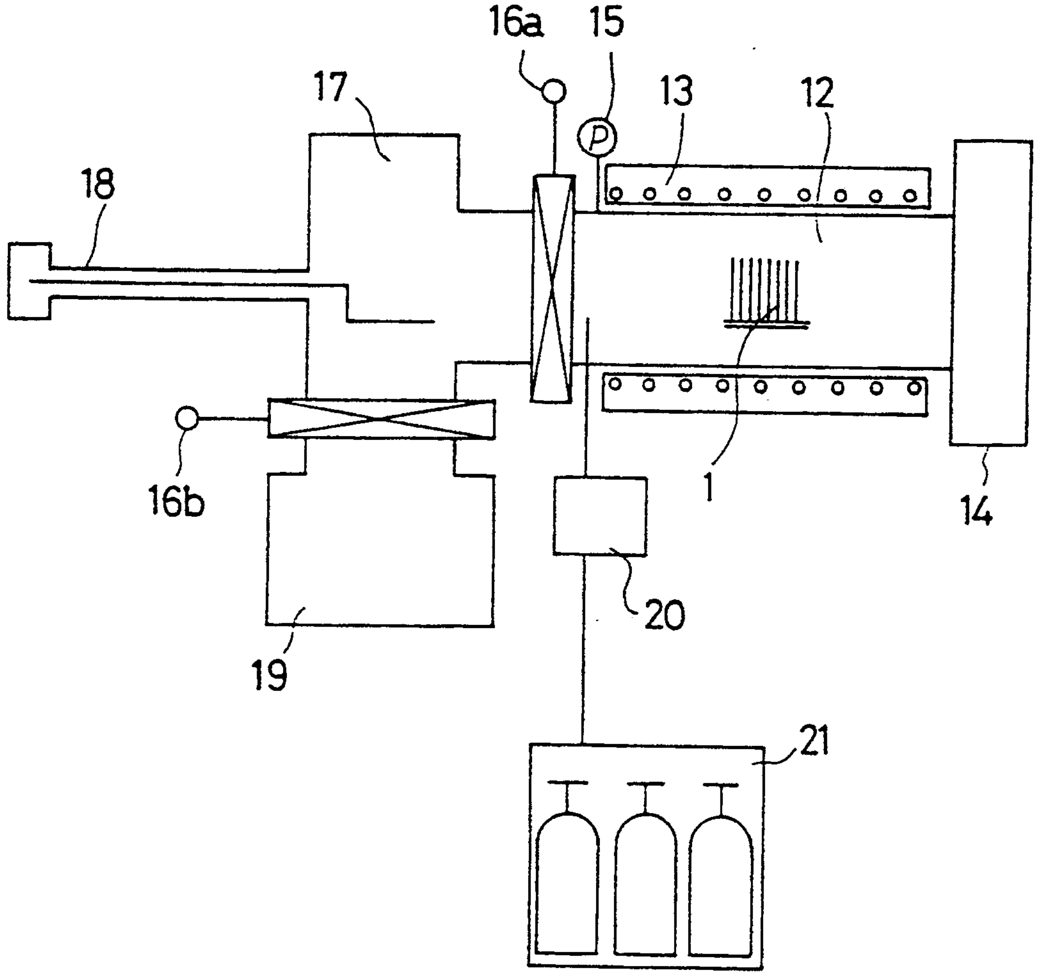

FIG. 3

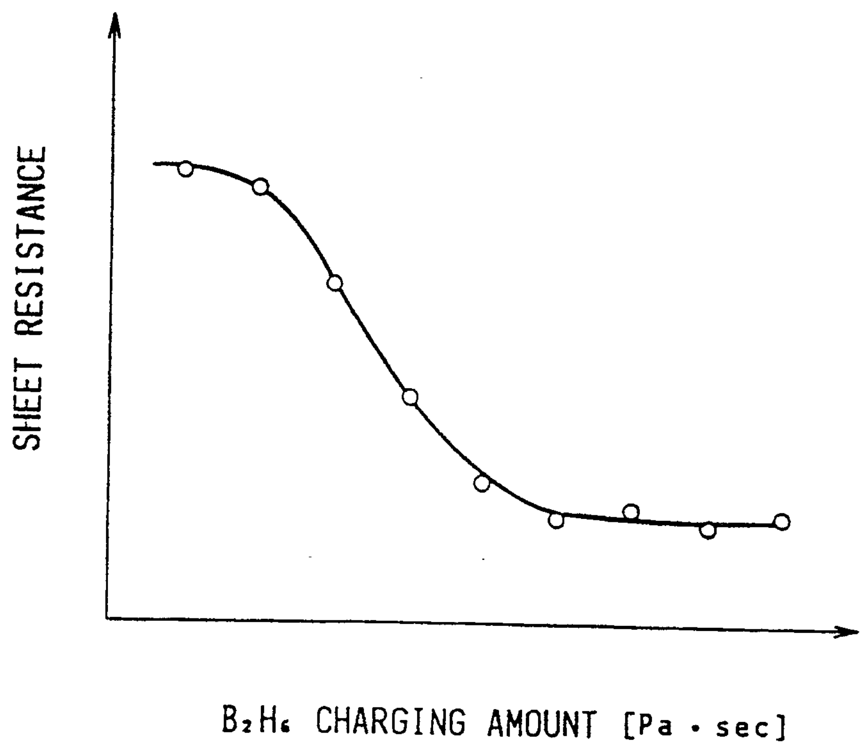

FIG. 4A

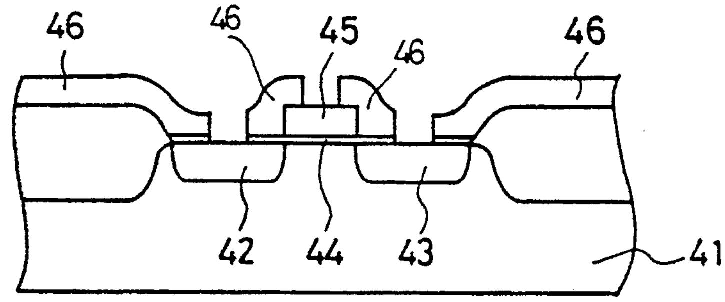


FIG. 4B

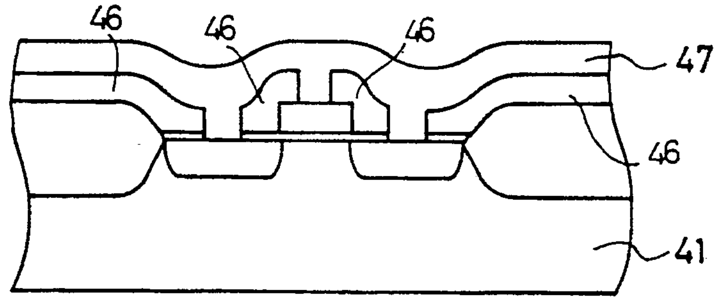


FIG. 4C

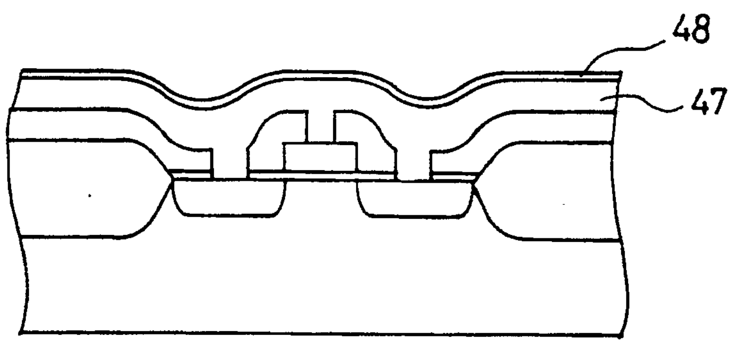


FIG. 4D

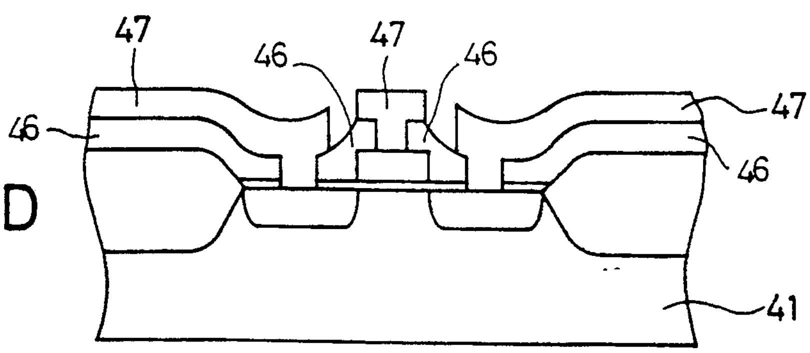

FIG.5A

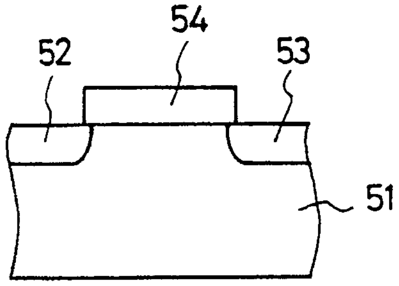


FIG.5C

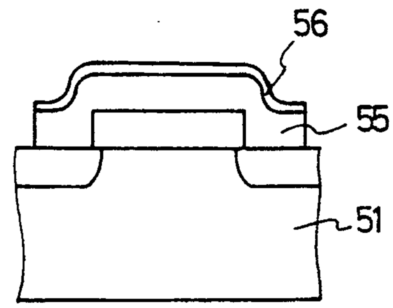


FIG.5B

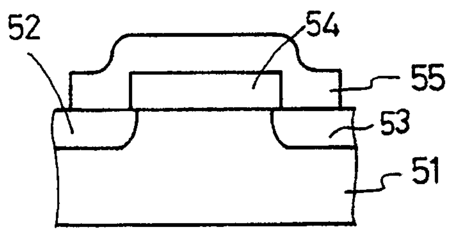


FIG.5D

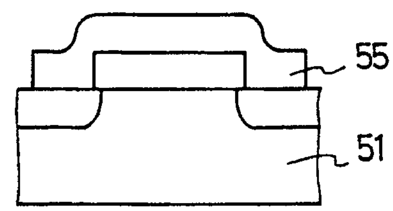


FIG.6A

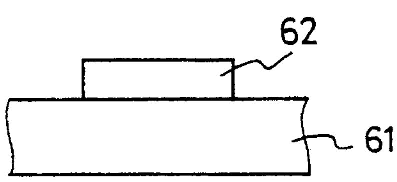


FIG.6C

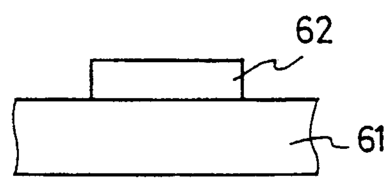


FIG.6B

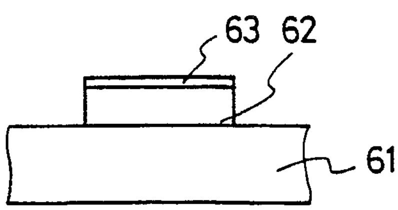


FIG.6D

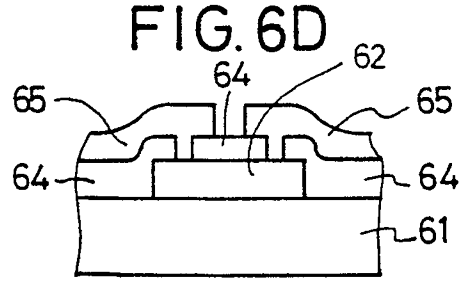

FIG. 7A

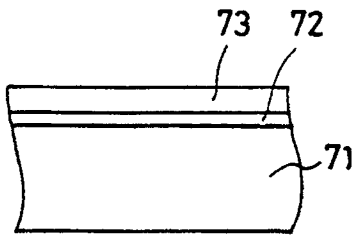


FIG. 7C

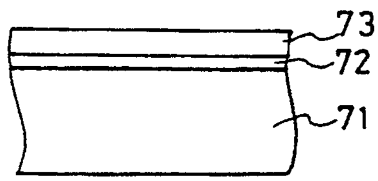


FIG. 7B

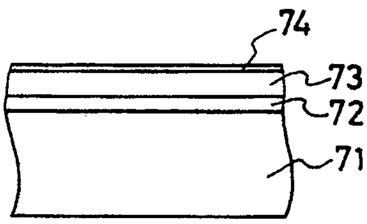


FIG. 7D

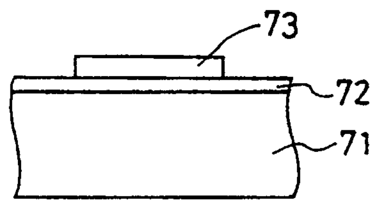


FIG. 8A

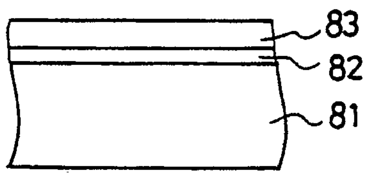


FIG. 8D

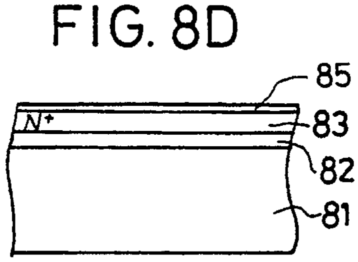


FIG. 8B

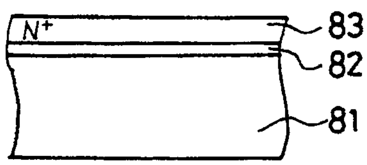


FIG. 8E

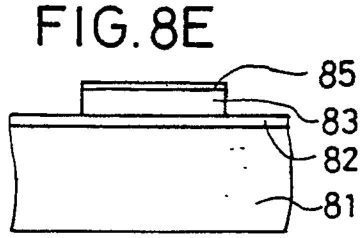


FIG. 8C

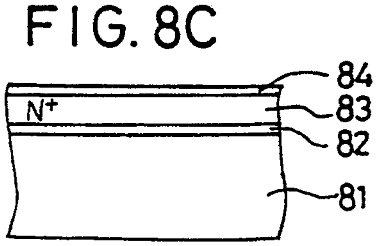

FIG. 9A

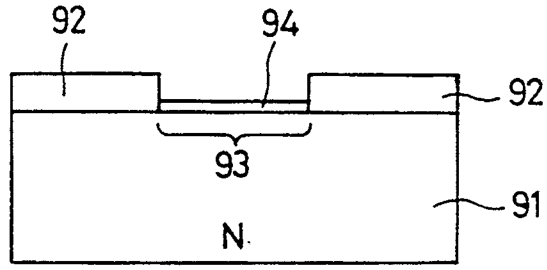


FIG. 9B

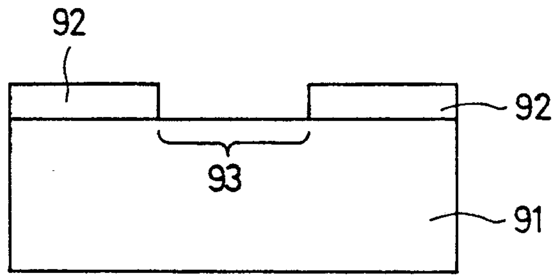


FIG. 9C

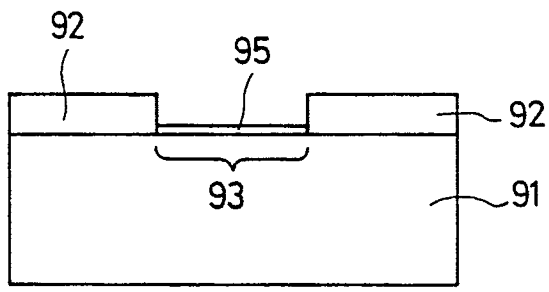


FIG. 9D

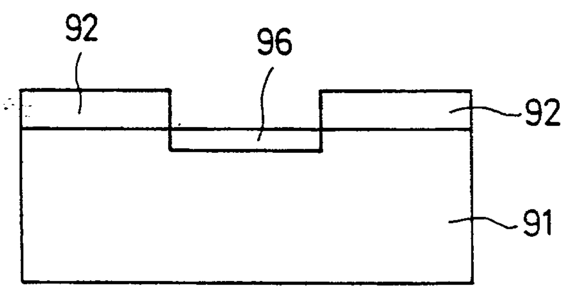


FIG. 9E

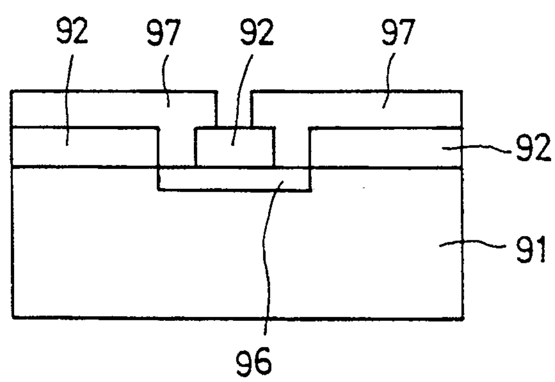

FIG. 10

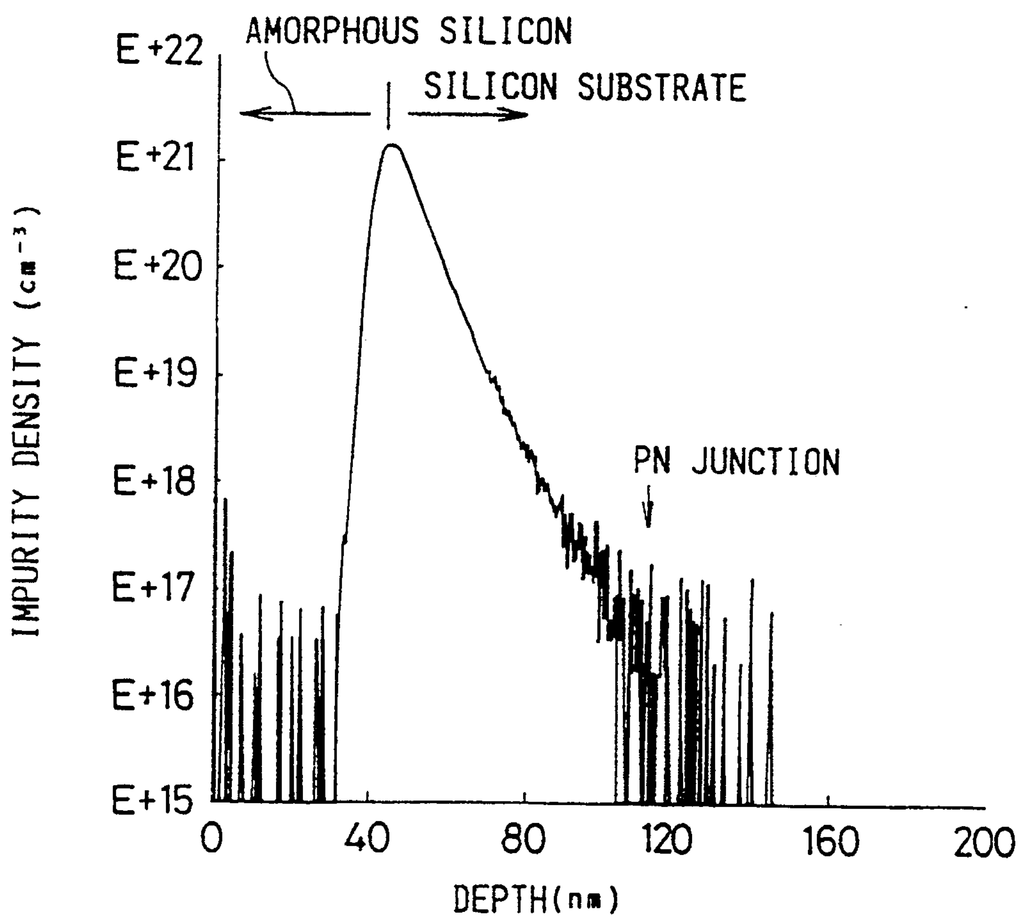
AMORPHOUS SILICON
SILICON SUBSTRATE
PN JUNCTION
IMPURITY DENSITY (cm⁻³)
E+22
E+21
E+20
E+19
E+18
E+17
E+16
E+15
0
40
80
120
160
200
DEPTH(nm)

FIG.11A

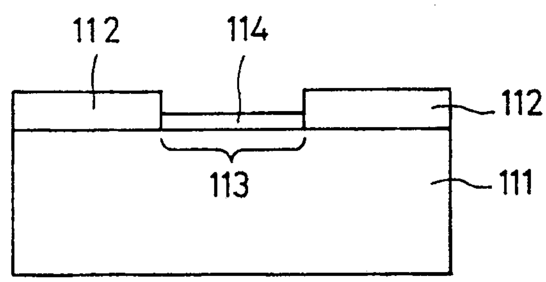


FIG.11B

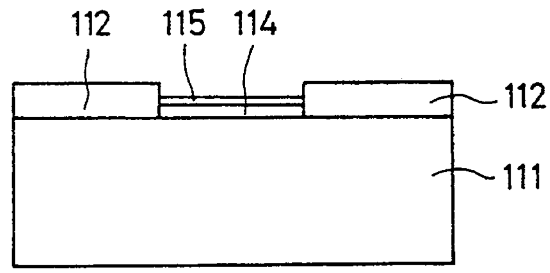


FIG.11C

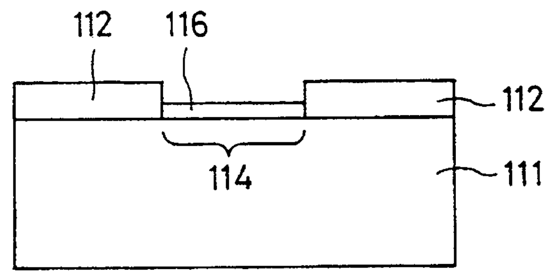


FIG. 12

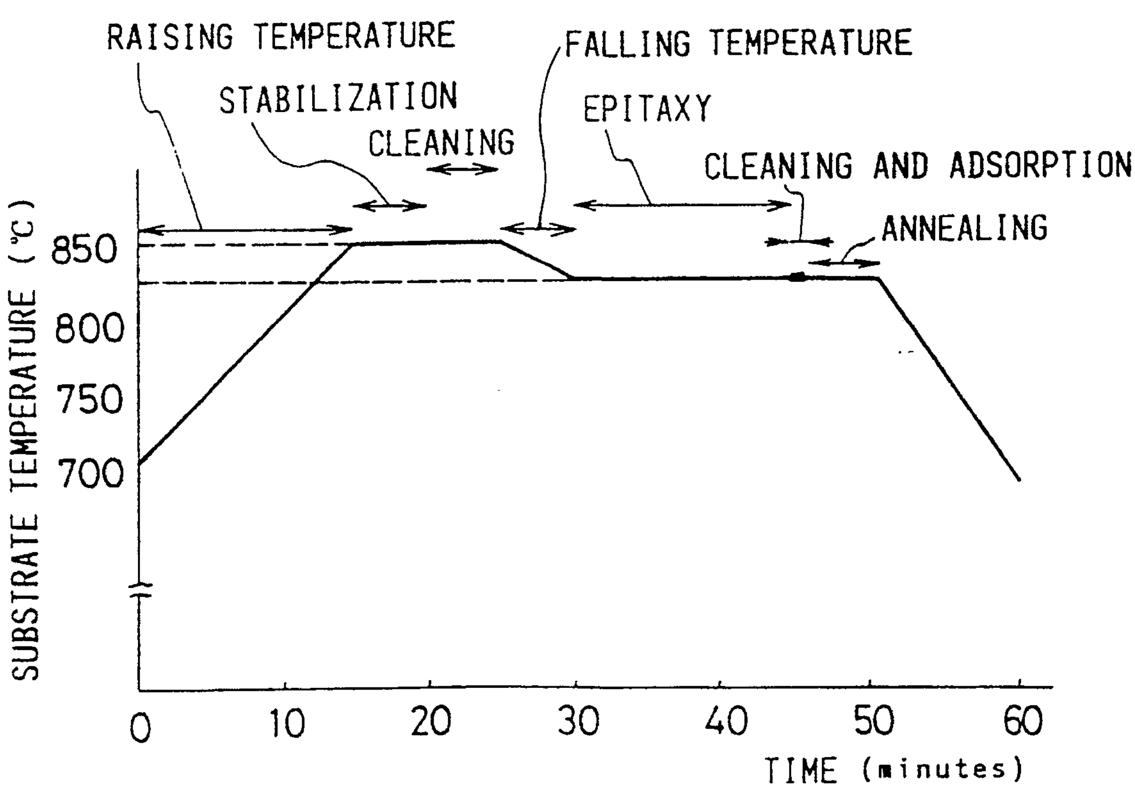

FIG. 13

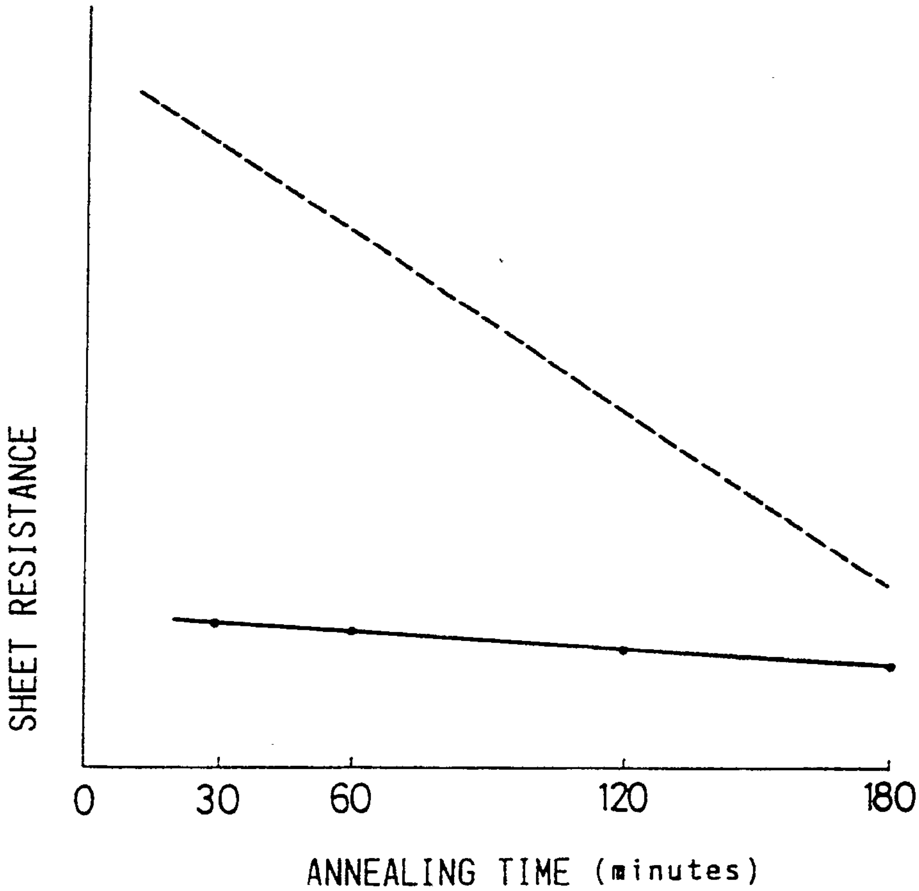


FIG. 14A

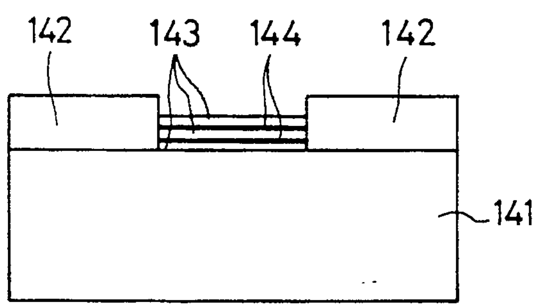


FIG. 14B